# FASCICULE DE BREVET EUROPEEN

(11) **EP 1 244 559 B1**
(45) Date de publication et mention de la délivrance du brevet: **13.08.2003**
(21) Numéro de dépôt: 00990828.6
(22) Date de dépôt: 27.12.2000
(51) Int. Cl.: B41N 1/12, G03F 7/09

(54) **PLAQUE COMPRESSIBLE POUR IMPRESSION FLEXOGRAPHIQUE ET PROCEDE D'OBTENTION**
KOMPRIMIERBARE FLEXODRUCKPLATTE UND VERFAHREN ZUR HERSTELLUNG
COMPRESSIBLE PLATE FOR FLEXOPGRAPHIC PRINTING AND METHOD FOR OBTAINING SAME

(30) Priorité: 31.12.1999 FR 9916815
(43) Date de publication de la demande: 02.10.2002
(73) Titulaire: MacDermid Graphic Arts S.A., 68700 Cernay (FR)
(72) Inventeur: KUCZYNSKI, Jerzy, F-68720 Zillisheim (FR); SCHANEN, Michel, F-68116 Guewenheim (FR); TEIXERA, Laurent, F-68740 Munchhouse (FR); RICH, Gérard, F-68500 Orschwihr (FR); SERAIN, Hugues, F-68700 Watwiller (FR)
(74) Mandataire: Berger, Helmut
(86) Numéro de dépôt international: FR0003699
(87) Numéro de publication internationale: WO01049510

(56) Documents cités:
- EP-A- 0 057 593
- EP-A- 0 177 302
- WO-A-96/40528
- US-A- 4 582 777

## Description

L'invention concerne une plaque compressible pour impression flexographique qui est destinée à être positionnée sur un cylindre support d'une machine à imprimer.

On connaît de nombreuses plaques d'impression qui comprennent une couche de photopolymère placée sur un support, qui est généralement un film de polyester. Avant que la plaque d'impression ne soit utilisée, la couche de photopolymère est développée pour recevoir l'image à imprimer. Ce développement consiste à exposer, à la lumière UV, la couche de photopolymère à travers un masque, les zones non exposées de la couche de photopolymère étant ensuite éliminées avec un solvant. On obtient alors une couche avec des reliefs qui permettra de reproduire l'image.

Après développement, les plaques d'impression sont montées sur un cylindre de support d'une machine à imprimer, notamment à l'aide d'adhésifs double face.

Il est déjà apparu nécessaire d'ajuster la compressibilité d'une plaque d'impression, notamment pour contrôler la pression dans le NIP, c'est-à-dire la zone de pincement entre deux cylindres. Le réglage de la compressibilité permet également d'augmenter la productivité et d'améliorer la qualité d'impression, notamment dans les quadrichromies.

La compressibilité peut être réglée au moyen d'un adhésif double face servant à la fixation de la plaque sur le cylindre support, cet adhésif double face étant lui-même compressible.

Cependant, ce type d'adhésif est onéreux. De plus, il grève de façon importante le budget de l'imprimeur et nécessite des opérations complexes et successives de montage.

Une autre solution connue dans l'état de la technique consiste à placer une couche compressible entre la couche de photopolymère et le support.

Ainsi, le document US-4 582 777 décrit une plaque compressible qui comporte depuis un film support destiné à être monté sur un cylindre d'impression, un adhésif, une couche compressible, un autre adhésif et une couche de photopolymère.

Cette plaque d'impression est d'une fabrication complexe puisqu'elle nécessite la présence d'un adhésif entre deux couches successives. Elle est donc d'un coût de fabrication élevé.

Le document EP-264 894 décrit une couche intermédiaire qui fait barrière entre une couche de photopolymère et une couche d'élastomère intermédiaire disposée entre la couche de photopolymère et la couche support. Cette couche intermédiaire peut être compressible.

La couche barrière évite la pénétration dans la couche intermédiaire, des solvants utilisés pour développer la couche de photopolymère. Cependant, sa présence complique la fabrication de la plaque compressible et grève également son coût.

Par ailleurs, aucune de ces plaques d'impression compressibles n'a eu d'application industrielle, ce qui tend à montrer qu'elles n'ont pas apporté satisfaction.

L'invention a tout d'abord pour objet de pallier ces inconvénients en proposant une plaque compressible pour impression flexographique qui ne nécessite pas l'utilisation d'adhésifs double face compressibles et qui est d'une réalisation simple, tout en apportant une grande qualité d'impression.

Par ailleurs, pour une même plaque d'impression, les imprimeurs doivent parfois faire face à des exigences contradictoires.

Ainsi, une pression d'impression forte facilite un transfert d'encre important, avec un "tendu" d'impression. Cette pression d'impression forte augmente la qualité d'impression des aplats.

Au contraire, c'est une pression d'impression faible qui permet d'optimiser la qualité d'impression en quadrichromie. Cette pression d'impression relativement faible est généralement obtenue grâce à une couche compressible tendre. Elle permet d'obtenir une impression fidèle en teinte et plus dépouillée, avec un engraissement faible dans les zones tramées.

Un compromis ne peut pas toujours être trouvé, à tel point que deux plaques d'impression sont souvent nécessaires pour imprimer une même couleur pour un sujet donné. Un imprimeur est donc souvent conduit à utiliser une plaque montée sur un support dur pour imprimer les textes et les aplats et une deuxième plaque d'impression identique dans sa nature mais avec une image complémentaire et qui est montée sur un assemblage compressible tendre, pour imprimer les demi-teintes.

Un autre but de l'invention est de supprimer l'utilisation de ces deux plaques et de fournir une plaque d'impression dont la compressibilité n'est pas uniforme sur toute la plaque d'impression, cette plaque permettant ainsi d'obtenir une qualité d'impression optimale tant pour les aplats qu'en quadrichromie.

Enfin, les plaques d'impression connues dans l'état de la technique sont livrées sous forme de feuilles d'un format donné, typiquement de 1016 mm x 1524 mm ou encore de 1321 mm par 2032 mm.

Cette présentation en feuilles est rendue nécessaire par la présence, sur un côté de la plaque, d'une couche support rigide et, sur l'autre côté de la plaque, c'est-à-dire sur la couche photosensible, d'un film de protection également rigide.

Cette présentation engendre des pertes importantes, d'au moins 10 %, lorsque les imprimeurs découpent les plaques au format d'impression, avant leur montage sur le cylindre support d'une machine à imprimer.

Ces pertes grèvent encore davantage le coût des plaques d'impression.

L'invention a également pour objet de s'affranchir de ces formats pour limiter les pertes lors de la découpe des plaques d'impression.

L'invention a donc tout d'abord pour objet une plaque d'impression flexographique compressible, destinée à être positionnée sur un cylindre support d'une machine à imprimer, cette plaque comprenant une couche de photopolymère et une couche compressible en un matériau présentant des vides formant entre 10 et 60 % en volume de cette couche compressible, le matériau incluant au moins 70 % en poids d'un polymère ou d'un mélange de polymères qui est compatible chimiquement avec le photopolymère.

Dans toute la description, on comprend qu'un polymère donné est compatible chimiquement avec un autre polymère lorsque leurs paramètres de solubilité sont proches et notamment lorsque leur différence est inférieure ou égale à 1.

La notion de paramètre de solubilité est bien définie pour l'homme du métier. On peut notamment se référer à l'ouvrage "Polymer Handbook" - J. Brandrup et E.M. Immergut. 1975 - Wiley - Interscience Publication John Wiley & Sons - et notamment au chapitre IV - 337 et s.

Pour la plupart des polymères, la valeur du paramètre de solubilité peut être déterminée directement ou indirectement au moyen de solvants.

Certains polymères comportent plusieurs phases différentes, chacune ayant un paramètre de solubilité spécifique. C'est notamment le cas du SEBS qui comporte une phase rigide styrénique et une phase élastomérique à base d'isobutylène et d'éthylène.

Pour ce type de polymère, on retient la valeur du paramètre de solubilité de la phase la plus importante en volume pour effectuer une comparaison avec la valeur du paramètre de solubilité d'un autre polymère et déterminer si ces deux polymères sont ou non compatibles.

De façon pratique, des polymères proches chimiquement sont compatibles. C'est par exemple le cas du SIS et du SBS ou SEBS, d'un PU (polyuréthane) polyester avec un autre PU de type polyester.

Par ailleurs, la liaison entre la couche de photopolymère et la couche compressible peut être obtenue chimiquement, sans qu'il soit nécessaire de prévoir une couche d'adhésif.

En effet, les polymères compatibles de la couche compressible et de la couche de photopolymère vont avoir tendance à créer une zone d'interdiffusion à l'interface qui va créer une adhésion forte.

La plaque compressible selon l'invention est donc d'une fabrication simplifiée et nécessairement d'un coût moindre que les plaques compressibles connues dans l'état de la technique, puisqu'elle ne nécessite pas de couche de liaison.

Par ailleurs, par un choix approprié des matériaux utilisés, on peut également éviter la migration de monomères d'une couche à l'autre. Ceci permet en outre d'éviter la présence d'une couche barrière tout en obtenant une stabilité dans le temps de la structure et de la composition de chacune des deux couches, quand elles sont en contact.

Ainsi, les monomères contenus dans la couche de photopolymère et notamment les agents de réticulation comme les acrylates ne vont pas migrer vers la couche compressible si leur paramètre de solubilité est plus proche de celui du photopolymère que de celui des polymères de la couche compressible. Il en est de même des autres ingrédients de la formulation, dont les photoinitiateurs.

Inversement, si la couche compressible comprend, comme on le verra ultérieurement, des monomères qui sont activés après la fabrication de la plaque d'impression, ces monomères ne migrent pas vers la couche de photopolymère s'ils ont un paramètre de solubilité plus proche de celui des polymères de la couche compressible que de celui du photopolymère.

Dans un mode avantageux de réalisation de la plaque d'impression selon l'invention, les vides présents dans la couche compressible sont constitués par des microsphères expansées. Ces microsphères représentent alors entre 1 et 10 % en poids du matériau constituant la couche compressible.

Par ailleurs, la couche compressible comprend entre 0,1 et 3 % en poids d'agents de protection, notamment choisis parmi les antioxydants, les antiozonants non tâchants de type phénolique ou les cires, pris isolément ou en mélange.

De façon préférée, la couche compressible comprend un polymère de base qui est choisi dans un des groupes suivants :
- Elastomères de type copolymères de styrène, par exemple copolymère styrène - isoprène - styrène (SIS), copolymère styrène - butadiène - styrène (SBS), copolymère styrène - diène -styrène (SDS), copolymère styrène - butadiène branché((S-B)x), copolymère styrène - éthylène, butylène - styrène (SEBS), copolymère styrène - éthylène, propylène-styrène (SEPS) simples et modifiés ; ces élastomères étant éventuellement mélangés avec des copolymères bi-bloc, comportant par exemple des groupes vinyliques, des chaînes greffées d'isoprène, des silanes ou anhydrides.
- Elastomères thermoplastiques obtenus par la vulcanisation dynamique, tels que par exemple les mélanges de type polypropylène/terpolymère éthylène - propylène -diène (PP/EPDM) ou polypropylène/copolymère butadiène - acrylonitrile (PP/NBR) ;
- Polyuréthanes thermoplastiques purs ou modifiés
   ou encore réticulés avec les isocyanates, par exemple polyuréthane thermoplastique (TPU) ou TPU modifié avec des fonctionnalités silanes ;
- Elastomères de type acrylonitrile, par exemple copolymère butadiène - acrylonitrile (NBR), copolymère butadiène - acrylonitrile carboxylé (XNBR), copolymère butadiène - acrylonitrile hydrogéné (HNBR) et élastomères de type copolymère butadiène -acrylonitrile (NBR) fonctionnalisés.

La couche compressible peut également comporter, outre le polymère de base, un autre polymère ou des additifs polymériques ou élastomériques qui sont choisis dans un ou plusieurs des groupes suivants :
- Polyoléfines fonctionnalisées, par exemple copolymères d'éthylène avec acétate de vinyle (EVA), avec alcool vinylique (EVOH) ou ester acrylique (diacrylate de bisphénol A éthoxylé (EBA), méthacrylate d'éthyle (EMA)) ;
- Terpolymères d'éthylène, d'acétate de vinyle ou d'ester acrylique avec anhydrique maléique ou méthacrylate de glycidile,
- Copolymères d'éthylène et d'octène, de propylène et d'hexène ou de decène,
- Polyester ou polyéther amides,
- Elastomères du type terpolymère éthylène - propylène - diène (EPDM), copolymère butadiène - acrylonitrile (NBR) ou copolymère butadiène - acrylonitrile hydrogéné (HNBR).

Ce ou ces autres polymères ou additifs polymériques et élastomériques permettent d'ajuster les propriétés mécaniques de la couche compressible.

La couche compressible de la plaque d'impression selon l'invention peut également comprendre des coagents notamment choisis parmi : les acrylates et méthacrylates mono et multi fonctionnels, par exemple méthacrylate d'hydroxypropyle (HPMA), triacrylate de triméthylolpropane (TMPTA), Triméthacrylate de triméthylolpropane (TMPTMA), 1,6-diacrylate de hexanediol (HDDA), ou 1,3- diméthacrylate de glycérol (GDMA), seuls ou en combinaison.

Les coagents sont des promoteurs de la réticulation radicalaire et peuvent être utilisés pour augmenter l'aptitude à la réticulation de la couche compressible.

La couche compressible peut également comprendre des polymères fonctionnels notamment choisis parmi les polymères liquides et par exemple, terpolymère éthylène - propylène - diène (EPDM), 1,2 polybutadiène (PB), hydroxy ou époxy poly (éthylène/butylène), ou copolymère butadiène - acrylonitrile (NBR) fonctionnalisé.

Ces polymères liquides sont des plastifiants polymériques.

Les définitions des composés seront les mêmes dans toute la description, même si par la suite, ils sont uniquement désignés par leurs abréviations.

La couche compressible de la plaque d'impression flexographique selon l'invention peut également comprendre des charges minérales, notamment du type silice, silicates, carbonates, stéarates, pures ou modifiées sur la surface.

Ces charges permettent d'ajuster les propriétés mécaniques de la couche compressible.

Des colorants peuvent également être prévus dans la couche compressible, notamment des pigments et des colorants organiques, purs ou sous forme de mélange.

Les colorants permettent d'ajuster la capacité de la couche compressible à absorber la lumière UV.

On pourrait également incorporer des absorbants UV dans la formulation de la couche compressible.

De façon préférée, les constituants de la couche compressible sont présents dans les proportions en poids suivantes :
- polymère de base : de 35 à 90 %
- autre polymère ou additifs polymériques ou élastomériques : de 0 à 60 %
- coagents et polymères fonctionnels: de 0 à 20 %
- charges : de 0 à 10 %
- microsphères : de 1 à 10 %
- colorants : de 0 à 1 %
- absorbants UV : de 0 à 0,5%
- agents de protection : de 0,1 à 3 %

Dans un mode préféré de réalisation, la couche compressible de la plaque d'impression flexographique selon l'invention comporte au moins un monomère fonctionnel qui n'a pas encore réagi avec les autres constituants du type polymère de la couche compressible, lors de la fabrication de la plaque, et qui est susceptible d'être activé ultérieurement, sous l'effet d'une contrainte déterminée, pour créer d'autres liaisons entre les chaînes de polymères ou en supprimer.

Si l'on souhaite que la plaque compressible présente plusieurs systèmes différents pour créer des liaisons entre les chaînes de polymères ou en supprimer, susceptibles d'être activés après la fabrication de la plaque, il convient de prévoir autant de monomères fonctionnels ou de mélanges de monomères fonctionnels que de tels systèmes.

La présence de ces monomères fonctionnels permet de modifier la compressibilité de la plaque d'impression flexographique, après sa fabrication. Ceci permet d'obtenir, à l'intérieur d'une même plaque d'impression, des zones de compressibilité différente, qui sont réparties de façon à ce que la plaque procure une impression de qualité, à la fois pour les aplats et les tramés.

De préférence, le ou les monomères fonctionnels sont choisis parmi les acrylates et méthacrylates mono et multifonctionnels, notamment du type méthacrylate d'hydroxypropyle (HPMA), triacrylate de triméthylolpropane (TMPTA), triméthacrylate de triméthylolpropane (TMPTMA), 1,6-diacrylate de hexanediol (HDDA), 1,3-diméthacrylate de glycérol (GDMA), seuls ou en combinaison.

Ces monomères sont activés par la lumière UV.

De façon avantageuse, est mélangé dans la couche compressible, à ce ou ces monomères fonctionnels, au moins un photoamorceur ou un photo initiateur, notamment utilisable pour développer une couche photosensible, de préférence résistant à la température. Ce photoamorceur ou photoinitiateur peut notamment être du type KIP 150 ou Esacure® KTO46.

La présence de ce photoamorceur ou photoinitiateur favorise la réaction des monomères, en présence de lumière UV.

Ce ou ces monomères fonctionnels représentent avantageusement entre 2 et 10 % en poids de la couche compressible, tandis que ce ou ces photoamorceurs ou photoinitiateurs représentent avantageusement entre 0 et 5 % en poids de la couche compressible.

Ainsi, la couche compressible de la plaque d'impression selon l'invention peut avantageusement comprendre un monomère fonctionnel qui permet de créer, sous insolation UV, par exemple apportée lors du développement de la couche photosensible de la plaque d'impression, des chaînes supplémentaires entre les constituants de type polymère de la couche compressible.

La plaque d'impression selon l'invention peut aussi comprendre une semelle, entre la couche de photopolymère et la couche compressible, qui est réalisée en un matériau compatible chimiquement avec les polymères de la couche de photopolymère et de la couche compressible.

De façon avantageuse, la plaque d'impression flexographique selon l'invention comporte une couche de stabilisation, entre la couche de photopolymère et la couche compressible.

Cette couche de stabilisation se présente par exemple sous la forme d'une couche d'élastomère, chimiquement compatible avec le photopolymère et avec le ou les polymères de la couche compressible, avec un renfort fibreux tissé ou non tissé.

La fonction de cette couche est de limiter la déformation de l'image dans le sens circonférentiel lors de l'impression, dans la zone de contact soumise à pression. Cette couche permet de mieux garantir la tenue des registres et de reproduire les images plus fidèlement.

Une autre fonction de cette couche de stabilisation est de garantir une stabilité dimensionnelle suffisante de la plaque compressible dans son plan lors des manipulations préalables à son positionnement sur un cylindre ou manchon et ce, notamment dans le cas particulier où la plaque ne comporte pas de couche support rigide telle que décrite plus loin.

La plaque d'impression flexographique selon l'invention peut également avantageusement comprendre, en surface de la couche de photopolymère, une couche de contraste.

Une telle couche de contraste est notamment décrite dans le brevet EP-0 456 336, auquel on peut se référer.

La plaque d'impression flexographique selon l'invention peut aussi comprendre, en surface de la couche de photopolymère, une couche permettant la réalisation d'une image sur la couche de photopolymère, par des moyens digitaux.

Une telle couche est notamment décrite dans le document PCT 97/25 206, auquel on peut se référer.

La plaque d'impression flexographique selon l'invention peut se présenter sous forme de feuille de format déterminé ou encore sous forme de rouleau.

La présentation sous forme de rouleau est rendue possible par le fait que la plaque d'impression selon l'invention peut ne pas comporter de couche de support rigide ou de feuille de protection, contrairement aux plaques connues dans l'état de la technique.

Cette présentation en forme de rouleau permet à l'utilisateur de découper des plaques d'impression au format souhaité, avant le développement de la couche photosensible pour générer une image.

La présentation sous forme de rouleau permet de limiter les pertes de découpe, par rapport à une présentation dans des formats fixés.

Lorsque la plaque d'impression selon l'invention se présente sous forme de feuille, elle peut être avantageusement munie sur sa face interne d'un film en matière plastique ou en métal qui assure une meilleure stabilité dimensionnelle de la plaque, lorsque celle-ci est manipulée avant son positionnement sur un cylindre.

Quelle que soit la présentation de la plaque, en feuille ou en rouleau, celle-ci peut être avantageusement munie sur sa face interne, d'un auto-adhésif. Il permet l'accrochage de la plaque compressible sur un film support, lui-même monté sur la machine à imprimer ou sur un manchon d'impression tel que celui décrit dans le brevet européen EP-0 683 040, auquel on pourra se reporter.

Cet auto-adhésif est prévu sur le film en matière plastique ou en métal, lorsque la plaque d'impression comporte un tel film.

La présence d'un auto-adhésif sur la face interne de la plaque compressible simplifie le montage de celle-ci et limite la quantité de produits consommables à acheter et à mettre en oeuvre par l'imprimeur.

L'invention concerne également une plaque d'impression flexographique telle que décrite précédemment et dont la couche de photopolymère a été développée.

L'invention concerne également un procédé de réalisation d'une plaque d'impression flexographique comprenant une couche de photopolymère, ce procédé comportant les étapes suivantes :
- Préparation d'un mélange comportant au moins 70 % en poids d'un ou plusieurs polymères compatibles chimiquement avec le photopolymère et 1 à 10 % en poids de microsphères à l'état expansé ou non-expansé ou mélanges des deux types de macrosphères, ou d'agents gonflants ;
- Extrusion de ce mélange, au cours de laquelle le mélange expanse, pour former une couche compressible présentant une multiplicité de vides ;
- Extrusion du photopolymère pour former la couche de photopolymère,
- Laminage de la couche de photopolymère contre la couche compressible préalablement formée, la pression d'une couche contre l'autre les faisant adhérer entre elles et
- Activation d'un système pour créer, dans la couche compressible, des chaînes de polymères longues reliées entre elles, cette étape d'activation pouvant être effectuée avant, pendant ou après le laminage de la couche de photopolymère contre la couche compressible.

Dans un premier mode de mise en oeuvre du procédé, le système pour créer des chaînes reliées entre elles est un système de réticulation, activé par exemple par la chaleur, par des isocyanates, par bombardement électronique ou encore par rayons X.

Dans un autre mode de mise en oeuvre du procédé, ce système pour créer des chaînes reliées entre elles consiste en un ancrage des chaînes de polymères, par l'intermédiaire d'une phase cristalline, à la température de fonctionnement ou à la température ambiante.

De façon avantageuse, la réticulation d'au moins une partie du mélange constituant la couche compressible est réalisée lors de l'extrusion du mélange, pour un système avec réticulation de type thermique.

Le procédé selon l'invention peut également comporter une étape de calibrage ou de rectification de la couche compressible, après son extrusion, pour garantir une épaisseur nominale constante.

De façon préférée, la couche compressible présente une épaisseur comprise entre 0,5 et 4,0 mm et, de préférence, entre 0,5 et 1,5 mm.

Le procédé selon l'invention est d'une mise en oeuvre simplifiée par rapport aux procédés de fabrication connus et permet un gain de productivité allant jusqu'à 30 %.

Le mélange comprend avantageusement entre 0,1 et 3 % en poids d'agents de protection, notamment choisis parmi les antioxydants, les antiozonants non tachants de type phénolique ou les cires, pris isolément ou en mélange.

De façon préférée, le mélange comprend un polymère de base qui est choisi dans un des groupes suivants :
- Elastomères de type copolymères de styrène, par exemple SIS, SBS, SDS, (S-B)x, SEBS, SEPS simples et modifiés ainsi que les mélanges de tels élastomères avec des copolymères bi-bloc, comportant soit des groupes vinyliques, des chaînes greffées d'isoprène, des silanes, ou anhydrides,
- Elastomères thermoplastiques obtenus par la vulcanisation dynamique tels que par exemple les mélanges de type PP/EPDM ou PP/NBR,
- Polyuréthanes thermoplastiques purs ou modifiés
   ou encore réticulés avec des isocyanates, par exemple TPU et TPU modifiés avec des fonctionnalités silanes ;
- Elastomères du type acrylonitrile par exemple NBR, XNBR, HNBR et élastomères NBR fonctionnalisés.

Le mélange peut également comprendre, outre le polymère de base, un autre polymère ou des additifs polymériques ou élastomériques qui sont choisis dans un ou plusieurs des groupes suivants :
- Polyoléfines fonctionnalisées, par exemple copolymères d'éthylène avec acétate de vinyle (EVA), avec alcool vinylique (EVOH) ou ester acrylique (EBA, EMA),
- Terpolymères d'éthylène, d'acétate de vinyle ou d'ester acrylique avec anhydride maléique ou méthacrylate de glycidile,
- Copolymères d'éthylène et d'octène, de propylène et d'hexène ou de decène,
- Polyester ou polyéther amides,
- Elastomères du type EPDM, NBR ou HNBR.

Le mélange constitutif de la couche compressible peut également comprendre des coagents notamment choisis parmi les acrylates et méthacrylates mono et multifonctionnels, par exemple HPMA, TMPTA, TMPTMA, HDDA, ou GDMA, seuls ou en combinaison.

Le mélange peut aussi comprendre des polymères fonctionnels notamment choisis parmi les polymères liquides, par exemple EPDM, 1,2 PB, hydroxy ou époxy poly (éthylène / butylène) ou NBR fonctionnalisé.

Ce mélange peut également comprendre des charges minérales, notamment du type silice, silicates, carbonates, stéarates, pures ou modifiées sur la surface.

Des colorants peuvent également être prévus dans le mélange, notamment des pigments et des colorants organiques, purs ou sous forme de mélange.

Les différents constituants du mélange permettant la formation de la couche compressible sont avantageusement présents dans le mélange dans les proportions suivantes en poids :
- Polymères de base : 35 à 90 %
- Autre élastomère ou additifs polymériques ou élastomériques : 0 à 60 %
- Coagents et polymères fonctionnels: 0 à 20 %
- Charges : 0 à 10 %
- Microsphères ou agents gonflants : 1 à 10 %
- Colorants ; 0 à 1 %
- Absorbants UV : 0 à 0,5%
- Agents de protection 0,1 à 3 %

La présence des microsphères ou d'agents de gonflement chimique, dans une proportion de 1 à 10 % en poids du mélange, permet d'obtenir dans la couche compressible extrudée, un taux de vide de 10 à 60 % en volume. Ce taux correspond à la fraction volumique de gaz présente dans la couche compressible après fabrication.

De préférence, la couche compressible présente des cellules fermées, qui sont plus résistantes mécaniquement et chimiquement.

Les microsphères contiennent un solvant qui, sous l'effet de la chaleur, à environ 100 à 150°C, provoquent l'expansion des microsphères.

Les agents de gonflement ont, eux, pour effet d'expanser chimiquement la couche compressible, pendant la phase de durcissement.

Le procédé selon l'invention consiste également à prévoir dans le mélange permettant la formation de la couche compressible, au moins un monomère fonctionnel qui ne réagit pas avec les autres constituants du type polymère de la couche compressible et qui est susceptible d'être activé ultérieurement sous l'effet d'une contrainte déterminée.

De préférence, le ou les monomères fonctionnels sont choisis parmi les acrylates et méthacrylates mono et multifonctionnels, notamment du type HPMA, TMPTA, TMPTMA, HDDA, GDMA, seuls ou en combinaison.

Ce ou ces monomères fonctionnels sont avantageusement mélangés à au moins un photoamorceur ou photoinitiateur, notamment utilisable pour développer une couche photosensible.

Lorsque le procédé consiste à prévoir de tels monomères dans le mélange, il comprend avantageusement une étape supplémentaire consistant à activer ce ou ces monomères fonctionnels pour modifier sélectivement la compressibilité de la plaque d'impression.

Dans la plaque compressible obtenue par le procédé selon l'invention, la couche de photopolymère présente avantageusement une épaisseur comprise entre 0,4 et 2,5 mm.

Le procédé selon l'invention peut également comporter une autre étape consistant en la réalisation d'une semelle entre la couche de photopolymère et la couche compressible.

La semelle présente, de préférence, une épaisseur comprise entre 0,1 et 2 mm.

Il peut également comporter une étape supplémentaire pour former une couche de stabilisation, entre la couche de photopolymère et la couche compressible, cette couche se présentant sous la forme d'une couche d'élastomère renforcée par un renfort fibreux, cet élastomère étant compatible chimiquement avec les polymères de la couche de photopolymère et de la couche compressible.

Cette couche de stabilisation présente, de préférence, une épaisseur comprise entre 0,2 et 0,5 mm.

L'invention sera mieux comprise et d'autres buts, avantages et caractéristiques de celle-ci apparaîtront plus clairement à la lecture de la description qui suit d'exemples non limitatifs de réalisation de l'invention et qui est faite en référence aux figures annexées sur lesquelles :
- La figure 1 est une vue schématique et en coupe d'une plaque compressible selon l'invention, comprenant une couche de photopolymère et une couche compressible,
- La figure 2 est une vue schématique et en coupe d'une plaque compressible selon l'invention comprenant une semelle entre la couche compressible et la couche de photopolymère,
- La figure 3 est une vue schématique et en coupe d'une plaque compressible selon l'invention comportant une couche de stabilisation entre la couche de photopolymère et la couche compressible,
- La figure 4 est une vue schématique et en coupe d'une plaque compressible selon l'invention comprenant une couche de photopolymère, une couche compressible et un film de support,
- La figure 5 consiste en deux courbes représentant la compression plane entre plateaux parallèles d'une plaque compressible selon l'invention (en microns) en fonction de la pression exercée sur la plaque (en kg/cm²).

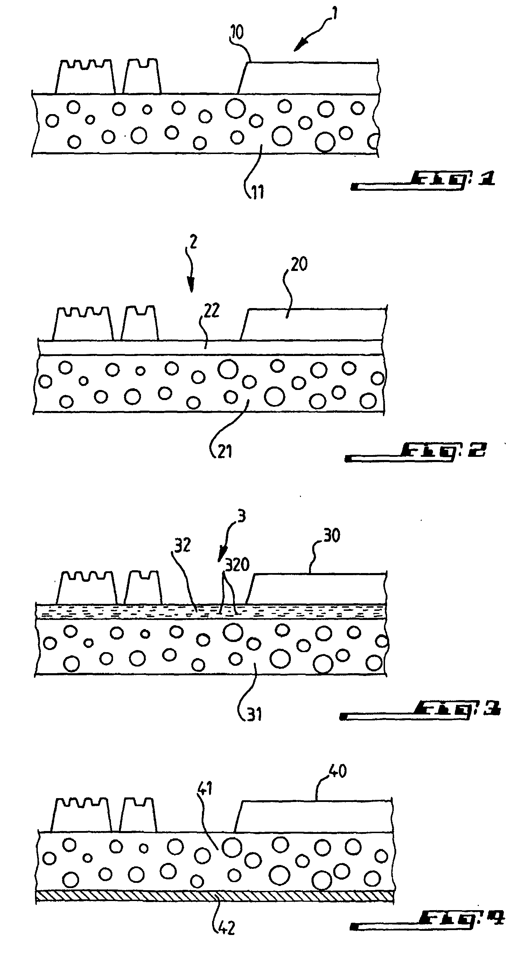

Sur les figures 1 à 4, la couche de photopolymère est représentée schématiquement non développée du côté droit de ces figures et, développée, du côté gauche de ces figures.

Une plaque compressible est généralement livrée aux photograveurs avec une couche photosensible non développée, comme représentée du côté droit de ces figures. Elle peut également être directement livrée à un imprimeur, après développement de la couche de photopolymère (comme illustré du côté gauche de ces figures).

On se réfère maintenant à la figure 1 qui illustre la version de base de la plaque d'impression compressible selon l'invention.

Cette plaque 1 comporte une couche de photopolymère 10 et une couche compressible 11.

Dans l'exemple illustré sur la figure 1, cette couche compressible 11 est réalisée à base de SEBS, tandis que la couche de photopolymère 10 est réalisée en SIS.

Cette couche compressible 11 est réalisée à partir d'un mélange comprenant 76 % en poids de SEBS, 16 % en poids d'un polymère de type oléfine fonctionnalisé, 5 % en poids de multi-acrylates, 2 % en poids de microsphères expansibles de type Expancell® (marque déposée de la société AKZO NOBEL) et du type DU et 1 % en poids d'agents de protection de type phénolique, tel que par exemple Irganex ®1010.

Ce mélange est tout d'abord extrudé et des vides sont créés à l'intérieur du mélange, grâce aux microsphères qui s'expansent lors de l'extrusion, sous l'effet du solvant qu'elles contiennent.

La couche d'élastomère est ensuite réticulée par bombardement électronique avec une dose de 25 à 250 kGy pour obtenir une tenue mécanique optimale et également une tenue au gonflement chimique.

L'efficacité du bombardement électronique est augmentée du fait de la présence de multi-acrylates dans le mélange.

De ce fait, la couche compressible 11 n'est pas affectée par l'agression des solvants, lors du développement de l'image de la couche photopolymère 10 et lors de l'impression en flexographie.

La couche compressible obtenue a un module élastique, mesuré en compression plane entre deux plateaux parallèles, qui est de l'ordre de 6 Mpa.

De façon générale, le module élastique d'une couche compressible pour une plaque d'impression selon l'invention est compris entre 1 et 25 Mpa et, de préférence, compris entre 2 et 15 Mpa.

Cette couche de photopolymère est donc réalisée à base de SIS et d'un photoinitiateur, comme décrit dans le document EP 0 456 336. Cette couche est ainsi réalisée à partir d'un mélange comprenant environ : 85% en poids de SIS, 4% en poids de HDDA, 3% en poids de HDDMA, 1,4% en poids d'un photoinitiateur de type Irgacure 651®, 1,4% en poids de 2,6 di-t-butylparacrésol, 0,2% en poids de stéarate de calcium, 0,64% en poids d'une cire paraffinique antiozonante, 4,3% en poids d'un polyisoprène dépolymérisé, 0,02% en poids de Tinurin 1130® et 0,04% en poids d'un antioxydant, du type Irganox 1010® de la société Ciba Geigy.

Ce mélange est extrudé puis appliqué avec une certaine pression contre la couche compressible 11 préalablement constituée.

Cette pression provoque une adhésion entre les deux couches 10 et 11, du fait que les deux matériaux sont compatibles chimiquement.

En effet, pour cette couche de photopolymère 10 et cette couche compressible 11, les paramètres de solubilité des monomères suivants sont à considérer :

| **Section de polymère considéré** | **Valeur de paramètre de solubilité** | **Unité** |
|---|---|---|
| Polyisoprène (dans le polymère SIS) | 8.2 | (Cal/cm³)^{1/2} |
| Polyisobutylène (dans le SEBS) | 7.85 | (Cal/cm³)^{1/2} |
| Polyéthylène (dans le SEBS) | 7.7 | (Cal/cm³)^{1/2} |
| Polystyrène (dans le SIS) (dans le SEBS) | 9.1 8,5 à 10,6 | (Cal/cm³)^{1/2} |
| Acrylates et méthacrylates | 8.3 à 8.9 | (Cal/cm³)^{1/2} |

Le paramètre de solubilité du SIS ici utilisé est d'environ 8,2. En effet, ce SIS particulier est à faible teneur styrénique et il présente sensiblement le même paramètre de solubilité que la section polyisoprène.

Par ailleurs, pour le SEBS, on retient le paramètre de solubilité de la phase élastomérique correspondant aux sections polyisobutylène et polyéthylène qui sont en quantités sensiblement égales dans le SEBS considéré. Le paramètre de solubilité du SEBS est donc d'environ 7,8.

Ainsi, la différence entre les deux paramètres de solubilité est bien inférieure à 1 et le SIS et le SEBS sont donc compatibles.

Par ailleurs, ce tableau fait apparaître que les valeurs des paramètres de solubilité des acrylates et méthacrylates sont plus proches du paramètre de solubilité de la section polyisoprène contenue dans le SIS de la couche de photopolymère que du paramètre de solubilité de la section polyéthylène dans le SEBS de la couche compressible.

Les acrylates contenus dans la couche de photopolymère n'ont donc pas tendance à migrer vers la couche compressible.

On constate aussi que le SIS et le SEBS sont chimiquement proches.

Par exemple, les blocs ou segments de polystyrène sont solubles l'un dans l'autre avec pour seule limitation l'influence du poids moléculaire des segments. Par ailleurs, le paramètre de solubilité du polyisoprène ne diffère de celui du polyéthylène ou de celui du polyisobutylène que d'une valeur inférieure à 0.5.

Cette compatibilité chimique entre les polymères utilisés dans ces deux couches assure tout d'abord une excellente adhésion et une bonne continuité entre les deux couches 10 et 11.

Par ailleurs, une migration ou une diffusion des monomères n'ayant pas réagi de la couche 10 vers la couche 11 ou inversement ne peut pas se produire et ceci, pour des raisons thermodynamiques.

Du fait de cette absence de migration, ces monomères ne peuvent pas altérer dans le temps l'une ou l'autre de ces deux couches qui sont liées entre elles.

Ceci a été vérifié expérimentalement par un essai de vieillissement accéléré.

Il a été réalisé en étuve à 45°C avec des durées étagées de 7, 14, 21 et 28 jours en comparaison directe entre la plaque selon l'invention et une plaque de référence de type EPIC (produit commercial de Polyfibron). Les mesures de dureté et de compression plane entre plateaux faites après chaque période de vieillissement n'ont pas montré d'évolution notable dans un sens ou dans l'autre pour les deux plaques.

La plaque compressible 1 selon l'invention est stable, sans qu'il soit nécessaire de prévoir une couche support au dos, c'est-à-dire du côté de la couche compressible opposée à la couche de photopolymère, cette couche support étant généralement constituée par un film de polyester dans l'état de la technique.

De ce fait, la plaque compressible selon l'invention peut aussi bien se présenter sous forme de feuille que de rouleau. Comme cela a été indiqué précédemment, cette présentation en rouleau représente un gain en rendement de découpe de l'ordre de 10 %.

Ainsi, la plaque d'impression selon l'invention peut être directement fixée sur un cylindre d'une machine à imprimer, par l'intermédiaire d'un auto-adhésif double-face dorsal.

Le développement de la plaque d'impression est réalisé de façon classique. Il est avantageusement effectué après la fixation de la plaque sur un film support ou sur un manchon.

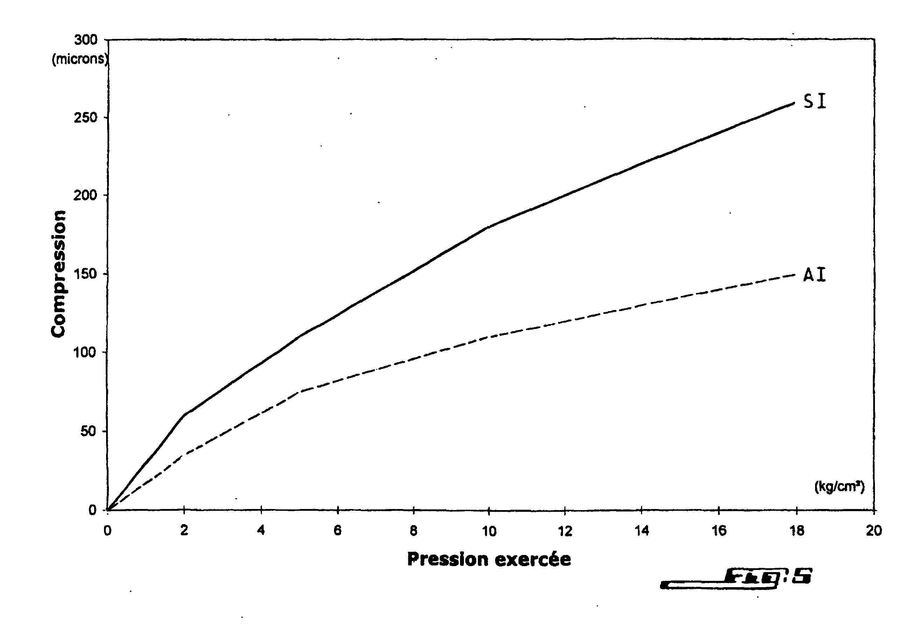

En référence maintenant à la figure 2, la plaque d'impression 2 selon l'invention peut également comporter une semelle 22 entre la couche de photopolymère 20 et la couche compressible 21.

Pour des raisons de simplicité, la semelle peut être réalisée avec le même matériau photopolymère que la couche de photopolymère 20 qui porte l'image. Elle peut également être réalisée en un matériau différent, dans la mesure où il est compatible chimiquement avec les polymères de la couche de photopolymère 20 et de la couche compressible 21.

Cette semelle est formée de façon préférée par insolation dorsale de la couche de photopolymère, avant ou après extrusion de la couche compressible.

Cette exposition dorsale est rendue possible par le fait que la couche compressible 21 est transparente aux UV. Comme cela a été indiqué précédemment, la présence de colorants dans la couche compressible 21 permet d'ajuster la capacité de la couche compressible à absorber ou à transmettre la lumière UV.

On se réfère maintenant à la figure 3 qui illustre une autre plaque d'impression compressible selon l'invention. Cette plaque 3 comporte une couche de stabilisation 32 entre la couche de photopolymère 30 et la couche compressible 31.

Cette couche de stabilisation 32 est réalisée à partir d'un élastomère et de fibres, se présentant de préférence sous la forme d'un renfort de type non tissé ou tissé.

Ce renfort fibreux 320 est, de préférence, de nature ouverte, afin de permettre une bonne imprégnation de ce renfort par le polymère de la couche de stabilisation.

Le module élastique de la couche de stabilisation dans le Nip, dans n'importe quelle direction dans le plan de la plaque compressible, est compris entre 50 et 2000 Mpa et, de préférence, entre 200 et 1000 Mpa.

Si la couche compressible 31 est, comme la couche 11 de la plaque 1 représentée à la figure 1, réalisée à base de SEBS, le polymère de la couche de stabilisation 32 sera également avantageusement du SEBS. Cependant, un autre polymère ou mélange de polymères pourrait être utilisé dans la mesure où il est compatible chimiquement avec les polymères de la couche de photopolymère 30 et de la couche compressible 31.

De préférence, le polymère de cette couche de stabilisation 32 présentera un indice de réfraction de la lumière UV prédéfini. Cet indice sera choisi pour faciliter la transmission de l'énergie incidente entre les couches 30 et 31.

Il sera également possible de rajouter des couches supplémentaires avec des indices de réfraction de la lumière tels qu'elles augmenteront la transmission de l'énergie incidente. Des absorbants UV peuvent aussi être incorporés dans ces couches supplémentaires.

Ces absorbants UV ont pour fonction de réduire ou d'éliminer la réflexion du rayonnement UV à l'interface entre les couches de photopolymère et la couche compressible. Cette réflexion peut provoquer une réticulation parasite et un bouchage des réserves (zones non réticulées typiquement dans un aplat d'impression) en cas d'épaisseurs faibles de la couche de photopolymère.

On se réfère maintenant à la figure 4 qui illustre une couche compressible 4 comprenant successivement une couche de photopolymère 40, une couche compressible 41 et un film support 42.

Ce film 42 peut être réalisé en matière plastique ou en métal. Il assure une meilleure stabilité dimensionnelle de la plaque, avant que celle-ci ne soit positionnée sur un cylindre.

Ce film est prévu plus particulièrement sur des plaques présentées sous forme de feuilles.

On va maintenant donner deux exemples de réalisation d'une plaque compressible selon l'invention qui comporte une couche compressible dont la compressibilité peut être modulée ou pilotée, après la fabrication de la plaque compressible.

### Exemple 1

Dans un premier exemple de réalisation d'une telle plaque, celle-ci comporte une couche compressible en polyuréthane expansé.

Cette couche compressible est obtenue à partir d'un prépolymère à terminaison isocyanate et d'un triol, un rallongeur de chaînes, un tensioactif et un catalyseur étant ajoutés au mélange. Dans ce mélange sont incorporés des monomères de type tétraacrylate de pentaérythritol et un photoinitiateur de type Irgacure 651®.

Les proportions en poids de ces constituants dans le mélange sont les suivantes : 85 % environ de polyol, 8 % environ de triol, 1 % environ de rallongeur de chaîne à terminaison isocyanate, 4 % environ de tétra-acrylate et 2 % environ de photoinitiateur.

Lors de l'extrusion de ce mélange, son expansion est obtenue en rajoutant de l'eau à raison de 0,1 partie en poids de polyol. Le premier système pour créer des chaînes de polymères reliées entre elles est un système de réticulation de type isocyanate.

On réalise ensuite une couche de photopolymère à base de polyuréthane, cette couche étant adhérisée sur la couche compressible, c'est-à-dire qu'une liaison irréversible s'établit entre les deux couches par interpénétration des chaînes de polymère en surface.

Ainsi, dans la plaque compressible obtenue, le système de réticulation du type isocyanate a déjà été activé pour former du polyuréthane.

Par contre, la couche compressible comporte des monomères, ceux du type tétraacrylate de pentaérythritol, qui n'ont pas encore réagi avec les autres constituants de la couche compressible.

La plaque d'impression obtenue pourra ultérieurement être irradiée avec un rayonnement UV, pour déclencher la réticulation du tétraacrylate et durcir la couche compressible.

Les monomères de type tétraacrylate de pentaérythritol constituent donc ici un système pour créer d'autres liaisons entre les chaînes de polymères qui est encore latent après la fabrication de la plaque et qui peut être activé ultérieurement.

Dans cet exemple particulier, le rayonnement UV peut notamment être apporté lors du développement de la couche de photopolymère de la plaque d'impression.

Ainsi, la réticulation qui se produit dans la couche compressible, lors de la fabrication de la plaque d'impression, permet d'obtenir une couche compressible tendre mais résistant chimiquement. Cette couche compressible permet le développement de la couche photosensible et optimise l'impression en quadrichromie des tramés.

Le système complémentaire de réticulation, dû à la présence des monomères de type tétraacrylate de pentaérythritol, permet de durcir la couche compressible, notamment lors de l'insolation de la plaque d'impression. Les parties de la couche compressible qui sont rendues plus dures permettent d'imprimer des aplats de grande qualité.

Lorsque l'insolation UV est utilisée pour durcir sélectivement la couche compressible, ce durcissement sélectif est obtenu sans opération supplémentaire, ce qui est un avantage notable pour les photograveurs.

On se réfèrera à la figure 5 qui représente deux courbes donnant la compression (en microns) de la plaque d'impression dont l'exemple vient d'être donné, en fonction de la pression exercée (en kg/cm²). On note que le module tangent des deux courbes SI et AI est dans un rapport de 1 à 1,75.

La courbe SI(-) correspond à des essais réalisés avec la plaque d'impression après sa fabrication et avant qu'elle ne soit soumise à une irradiation UV.

La courbe AI(---) correspond à des essais réalisés avec cette même plaque mais dans des zones qui ont été soumises à une irradiation UV.

Ces deux courbes AI et SI illustrent que la plaque d'impression a été durcie de façon notable dans les zones qui ont été soumises à une irradiation UV.

Bien entendu, l'irradiation en lumière UV peut être modulée en durée et en énergie ce qui permet également de moduler la dureté apportée à la couche compressible.

Dans l'exemple mentionné ci-dessus, la plaque compressible est durcie selon une répartition spatiale correspondant à l'image à imprimer.

On pourrait cependant choisir tout autre répartition spatiale qui serait favorable à l'impression. La plaque d'impression pourrait également être soumise à une insolation uniforme, afin de durcir la plaque uniformément.

En pratique, le photograveur ou l'imprimeur a ainsi la possibilité de choisir la compressibilité de la plaque d'impression, en fonction de ses besoins.

### Exemple 2

Un autre exemple de plaque d'impression selon l'invention dont la compressibilité peut être modulée va maintenant être donné.

Cette plaque d'impression comporte une couche compressible en SEBS.

Ainsi cette couche compressible est obtenue par extrusion d'un mélange comportant du SEBS, des microsphères expansées et non expansées du type Expancell®, des monomères fonctionnels du type tétraacrylate de pentaérythritol et un ou des photoinitiateurs de type Irgacure 651®.

Ces monomères fonctionnels représentent entre 2 et 10 % en poids du mélange et de préférence environ 5% en poids, tandis que les autres constituants se trouvent dans le mélange dans les proportions en poids suivantes :
SEBS, de 46 à 94 % et, de préférence, entre 61,95 et 83,65 %
Colorants de 0,01 à 1 % et, de préférence 0,05 %
Microsphères de 1 à 10 % et, de préférence 3 à 5 %
Additifs polymériques de 3 à 15 %
Agents de protection de 0,1 à 3 %
Photoamorceurs de 0,2 à 5 %
Charges de 0 à 10 % et, de préférence 5 %.

La couche compressible est réticulée par bombardement électronique avec une dose de 25 à 250 kGy environ, lors de la fabrication de la plaque compressible.

Dans cette plaque d'impression fabriquée, les monomères fonctionnels n'ont pas encore été activés et ils pourront l'être grâce à une exposition UV ultérieure, de façon à durcir sélectivement la couche compressible, comme cela a déjà été décrit pour le premier exemple ci-dessus.

On pourrait également envisager d'autres exemples de plaque compressible, comprenant des monomères fonctionnels différents et susceptibles d'être activés par des contraintes différentes, afin de pouvoir moduler encore davantage la compressibilité de la plaque.

Les monomères fonctionnels prévus dans la couche compressible peuvent conduire à créer d'autres liaisons entre les chaînes de polymères, comme le montrent les deux exemples illustrés ci-dessus.

On peut également prévoir des monomères qui suppriment des chaînes de polymères, lorsqu'ils sont activés.

Dans ce cas, la couche compressible obtenue lors de la fabrication de la plaque compressible sera relativement dure, cette couche étant ultérieurement assouplie lorsque ces monomères seront activés.

De façon générale, une plaque d'impression dont la compressibilité peut être modulée permet une meilleure standardisation de son épaisseur.

Surtout, la modulation de la compressibilité dans la plaque permet d'éviter l'utilisation d'auto-adhésifs différents plus ou moins compressibles, deux plaques d'épaisseur différentes ou encore plusieurs plaques différentes, comme c'est le cas dans l'état de la technique.

De façon générale, une plaque compressible selon l'invention, prête à l'emploi présente une épaisseur comprise entre 0,76 et 6,25 mm.

Elle présente, de préférence, une épaisseur comprise entre 1,0 et 2,8 mm.

Elle peut également présenter une épaisseur normalisée dans l'industrie qui peut être de 1,14 mm, 1,70 mm, 2,29 mm, 2,54 mm, 2,70 mm, 2,84 mm, 3,17 mm, 3,94 mm ou encore 4,32 mm.

La plaque compressible peut également présenter une épaisseur normalisée de 1,59 mm, 2,15 mm ou 2,74 mm. Cette épaisseur correspond à celle d'une plaque normalisée augmentée de l'épaisseur d'une couche compressible standard.

Enfin, la plaque d'impression selon l'invention présente, de préférence, une épaisseur normalisée de 1,59 mm, 2,15 mm, 2,29 mm ou 2,7 mm.

La plaque d'impression flexographique selon l'invention peut être utilisée de façon classique.

Elle est notamment fixée de façon sélective, sur un manchon ou un film support, avant insolation UV, et cela, aux emplacements qui comportent des zones à imprimer.

Ceci permet de gagner du temps au montage, d'éviter des risques d'erreurs humaines et garantit également un repérage parfait lorsque le développement de la plaque compressible est effectué après le montage.

On peut prévoir une insolation UV de la plaque d'impression par des moyens traditionnels ou digitaux, après son montage sur un film ou un manchon.

Les signes de référence insérés après les caractéristiques techniques figurant dans les revendications ont pour seul but de faciliter la compréhension de ces dernières et ne sauraient en limiter la portée.

## Revendications

1. Plaque d'impression flexographique compressible, destinée à être positionnée sur un cylindre support d'une machine à imprimer, cette plaque (1, 2, 3, 4) comprenant une couche de photopolymère (10, 20, 30, 40) et une couche compressible (11, 21, 31, 41) en un matériau présentant des vides formant entre 10 et 60 % en volume de cette couche compressible, le matériau incluant au moins 70 % en poids d'un polymère ou d'un mélange de polymères qui est compatible chimiquement avec le photopolymère.

2. Plaque d'impression selon la revendication 1, dans laquelle les vides présents dans la couche compressible sont constitués par des microsphères expansées.

3. Plaque d'impression selon la revendication 2, dans laquelle les microsphères représentent entre 1 et 10 % en poids du matériau constituant la couche compressible.

4. Plaque d'impression selon l'une des revendications 1 à 3, dans laquelle la couche compressible comprend entre 0, et 3 % en poids d'agents de protection, notamment choisis parmi les antioxydants, les antiozonants non tachants de type phénolique ou les cires, pris isolément ou en mélange.

5. Plaque compressible selon l'une des revendications 1 à 4, dans laquelle la couche compressible comprend un polymère de base qui est choisi dans un des groupes suivants :
- Elastomères de type copolymères de styrène, par exemple SIS, SBS, SDS, (S-B)x, SEBS, SEPS simples et modifiés ; ces élastomères étant éventuellement mélangés avec des copolymères bi-bloc, comportant par exemple des groupes vinyliques, des chaînes greffées d'isoprène, des silanes ou anhydrides.
- Elastomères thermoplastiques obtenus par la vulcanisation dynamique, tels que par exemple les mélanges de type PP/EPDM ou PP/NBR ;
- Polyuréthanes thermoplastiques purs ou modifiés ou encore réticulés avec les isocyanates, par exemple TPU ou TPU modifié avec des fonctionnalités silanes ;
- Elastomères de type acrylonitrile, par exemple NBR, XNBR, HNBR et élastomères NBR fonctionnalisés.

6. Plaque d'impression selon la revendication 5, dans laquelle la couche compressible comporte également, outre le polymère de base un autre polymère ou des additifs polymériques ou élastomériques qui sont choisis dans un ou plusieurs des groupes suivants :
- Polyoléfines fonctionnalisées, par exemple copolymères d'éthylène avec acétate de vinyle (EVA), avec alcool vinylique (EVOH) ou ester acrylique (EBA, EMA) ;
- Terpolymères d'éthylène, d'acétate de vinyle ou d'ester acrylique avec anhydrique maléique ou méthacrylate de glycidile,
- Copolymères d'éthylène et d'octène, de propylène et d'hexène ou de decène,
- Polyester ou polyéther amides,
- Elastomères du type EPDM, NBR ou HNBR.

7. Plaque d'impression selon la revendication 5 ou 6, dans laquelle la couche compressible comprend des coagents notamment choisis parmi acrylates et méthacrylates mono et multi fonctionnels, par exemple HPMA, TMPTA, TMPTMA, HDDA, ou GDMA, seuls ou en combinaison.

8. Plaque d'impression selon les revendications 5 à 7, dans laquelle la couche compressible comprend des polymères fonctionnels notamment choisis parmi les polymères liquides et par exemple, EPDM 1,2 PB, hydroxy ou époxy poly (éthylène/butylène), ou NBR fonctionnalisé.

9. Plaque d'impression selon l'une des revendications 5 à 8, dans laquelle la couche compressible comprend des charges minérales, notamment du type silice, silicates, carbonates, stéarates pures ou modifiées sur la surface.

10. Plaque d'impression selon l'une des revendications 5 à 9, dans laquelle la couche compressible comprend des colorants, notamment des pigments et des colorants organiques, purs ou sous forme de mélange.

11. Plaque d'impression selon l'une des revendications 5 à 10, dans laquelle les constituants de la couche compressible sont présents dans les proportions en poids suivantes :
- Polymères de base : de 35 à 90 %
- Autres polymères ou additifs polymériques ou élastomériques : de 0 à 60 %
- Coagents et polymères fonctionnels: de 0 à 20 %
- Charges : de 0 à 10 %
- Colorants : de 0 à 1 %
- Microsphères : de 1 à 10 %
- Agents de protection : de 0,1 à 3 %.

12. Plaque d'impression selon l'une des revendications 1 à 11, dans laquelle la couche compressible comporte au moins un monomère fonctionnel qui n'a pas encore réagi avec les autres constituants du type polymère de la couche compressible lors de la fabrication de la plaque et qui est susceptible d'être activé ultérieurement, sous l'effet d'une contrainte déterminée, pour créer d'autres liaisons entre les chaînes de polymères ou en supprimer.

13. Plaque d'impression selon la revendication 12, dans laquelle le ou les monomères fonctionnels sont choisis parmi les acrylates et méthacrylates mono et multifonctionnels du type HPMA, TMPTA, TMPTMA, HDDA, GDMA, seuls ou en combinaison.

14. Plaque d'impression selon la revendication 12 ou 13, dans laquelle est mélangé, dans la couche compressible, à ce ou ces monomères fonctionnels, au moins un photoarmorceur ou un photoinitiateur, notamment utilisable pour développer une couche photosensible.

15. Plaque d'impression selon l'une des revendications 12 à 14, dans laquelle ce ou ces monomères fonctionnels représentent entre 2 et 10 % en poids de la couche compressible, tandis que ce ou ces photoarmorceurs ou photoinitiateurs sont présents entre 0 et 5 % en poids de la couche compressible.

16. Plaque d'impression selon l'une des revendications 1 à 15, comportant une semelle, entre la couche de photopolymère et la couche compressible, réalisée en un matériau chimiquement compatible avec les polymères de la couche de photopolymère et de la couche compressible.

17. Plaque d'impression selon l'une des revendications 1 à 16, comportant une couche de stabilisation, entre la couche de photopolymère et la couche compressible.

18. Plaque d'impression selon la revendication 17, dans laquelle la couche de stabilisation se présente sous la forme d'une couche d'élastomère, chimiquement compatible avec le photopolymère et avec le ou les polymères de la couche compressible, avec un renfort fibreux tissé ou non tissé.

19. Plaque d'impression selon l'une des revendications 1 à 18, comprenant également, en surface de la couche de photopolymère, une couche de contraste.

20. Plaque d'impression flexographique selon l'une des revendications 1 à 19, comprenant également, en surface de la couche de photopolymère, une couche permettant la réalisation d'une image sur la couche de photopolymère, par des moyens digitaux.

21. Plaque d'impression selon l'une des revendications 1 à 20, se présentant sous forme de feuille et comportant sur sa face interne, un film en matière plastique ou en métal.

22. Plaque d'impression selon l'une des revendications 1 à 21, comportant sur sa face interne, un auto-adhésif.

23. Plaque d'impression flexographique selon l'une des revendications 1 à 22, dont la couche de photopolymère est développée.

24. Procédé de réalisation d'une plaque d'impression flexographique comprenant une couche de photopolymère, ce procédé comportant les étapes suivantes :
- Préparation d'un mélange comportant au moins 70 % en poids d'un ou plusieurs polymères compatibles chimiquement avec le photopolymère, 1 à 10 % en poids de microsphères à l'état expansé ou non-expansé ou mélanges des deux types de microsphères
ou d'agents gonflants ;
- Extrusion de ce mélange, au cours de laquelle le mélange expanse, pour former une couche compressible présentant une multiplicité de vides ;
- Extrusion du photopolymère pour former la couche de photopolymère,
- Laminage de la couche de photopolymère contre la couche compressible préalablement formée, la pression d'une couche contre l'autre les faisant adhérer entre elles et
- Activation d'un système pour créer, dans la couche compressible, des chaînes de polymères longues reliées entre elles, cette étape d'activation pouvant être effectuée avant ou après le laminage de la couche de photopolymère contre la couche compressible.

25. Procédé selon la revendication 24, dans lequel le système pour créer des chaînes de polymères longues reliées entre elles est un système de réticulation, activé par exemple par la chaleur, par des isocyanates, par bombardement électronique ou encore par rayons X.

26. Procédé selon la revendication 24, dans lequel le système pour créer des chaînes de polymères reliées entre elles consiste en un ancrage des chaînes de polymères par l'intermédiaire d'une phase cristalline, à la température de fonctionnement ou à la température ambiante.

27. Procédé selon l'une des revendications 24 à 26, comprenant une étape supplémentaire de calibrage ou de rectification de la couche compressible, après son extrusion.

28. Procédé selon l'une des revendications 24 à 27, dans lequel le mélange comprend entre 0,1 et 3 % en poids d'agents de protection, notamment choisis parmi les antioxydants, les antiozonants non tachants de type phénolique ou les cires, pris isolément ou en mélange.

29. Procédé selon l'une des revendications 24 à 27, dans lequel le mélange comprend un polymère de base qui est choisi dans un des groupes suivants :
- Elastomères de type copolymères de styrène, par exemple SIS, SBS, SDS, (S-B)x, SEBS, SEPS simples et modifiés ainsi que les mélanges de tels élastomères avec des copolymères bi-bloc, comportant soit des groupes vinyliques, des chaînes greffées d'isoprène, des silanes, ou anhydrides,
- Elastomères thermoplastiques obtenus par la vulcanisation dynamique tels que par exemple les mélanges de type PP/EPDM ou PP/NBR,
- Polyuréthanes thermoplastiques purs ou modifiés
ou encore réticulés avec des isocyanates, par exemple TPU et TPU modifiés avec des fonctionnalités silanes ;
- Elastomères du type acrylonitrile par exemple NBR, XNBR, HNBR et élastomères NBR fonctionnalisés.

30. Procédé selon la revendication 29, dans lequel le mélange peut également comprendre, outre le polymère de base, un autre polymère ou des additifs polymériques ou élastomériques qui sont choisis dans un ou plusieurs des groupes suivants :
- Polyoléfines fonctionnalisées, par exemple copolymères d'éthylène avec acétate de vinyle (EVA), avec alcool vinylique (EVOH) ou ester acrylique (EBA, EMA),
- Terpolymères d'éthylène, d'acétate de vinyle ou d'ester acrylique avec anhydride maléique ou méthacrylate de glycidile,
- Copolymères d'éthylène et d'octène, de propylène et d'hexène ou de decène,
- Polyester ou polyéther amides,
- Elastomères du type EPDM, NBR ou HNBR.

31. Procédé selon la revendication 29 ou 30, dans lequel le mélange constitutif de la couche compressible comprend également des coagents notamment choisis parmi les acrylates et méthacrylates mono et multifonctionnels, par exemple HPMA, TMPTA, TMPTMA, HDDA, ou GDMA, seuls ou en combinaison,

32. Procédé selon l'une des revendications 29 à 31, dans lequel le mélange constitutif de la couche comprend également des polymères fonctionnels notamment choisis parmi les polymères liquides, par exemple EPDM, 1,2 PB, hydroxy ou époxy poly (éthylène / butylène) ou NBR fonctionnalisé.

33. Procédé selon l'une des revendications 29 à 32, dans lequel le mélange comprend également des charges minérales, notamment du type silice, silicates, carbonates, stéarates, pures ou modifiées sur la surface.

34. Procédé selon l'une des revendications 29 à 33, dans lequel le mélange comprend également des colorants, notamment des pigments et des colorants organiques, purs ou sous forme de mélange.

35. Procédé selon l'une des revendications 29 à 34, dans lequel les différents constituants du mélange permettant la formation de la couche compressible sont présents dans le mélange dans les proportions suivantes en poids :
- Polymères de base : ou élastomériques : de 0 à 60 % 35 à 90 %
- Autre élastomère ou additifs polymériques ou élastomériques : ou élastomériques : de 0 à 60 % 0 à 60 %
- Coagents et polymères fonctionnels: ou élastomériques : de 0 à 60 % 0 à 20 %
- Charges : ou élastomériques : de 0 à 60 % 0 à 10 %
- Microsphères ou agents gonflants : ou élastomériques : de 0 à 60 % 1 à 10 %
- Colorants : ou élastomériques : de 0 à 60 % 0 à 1 %
- Agents de protection ou élastomériques : de 0 à 60 % 0,1 à 3 %

36. Procédé selon l'une des revendications 29 à 35, dans lequel le mélange permettant la formation de la couche compressible, comprend au moins un monomère fonctionnel qui ne réagit pas avec les autres constituants du type polymère de la couche compressible et qui est susceptible d'être activé ultérieurement sous l'effet d'une contrainte déterminée.

37. Procédé selon la revendication 36, dans lequel le ou les monomères fonctionnels sont choisis parmi les acrylates et méthacrylates mono et multifonctionnels, notamment du type HPMA, TMPTA, TMPTMA, HDDA, GDMA, seuls ou en combinaison.

38. Procédé selon la revendication 36 ou 37, dans lequel ce ou ces monomères fonctionnels sont avantageusement mélangés à au moins un photoamorceur ou photoinitiateur.

39. Procédé selon l'une des revendications 36 à 38, comprenant une étape supplémentaire consistant à activer ce ou ces monomères fonctionnels pour modifier sélectivement la compressibilité de la plaque d'impression.

40. Procédé selon l'une des revendications 24 à 39, comportant une étape supplémentaire consistant en la réalisation d'une semelle entre la couche de photopolymère et la couche compressible.

41. Procédé selon l'une des revendications 29 à 40, comprenant une étape supplémentaire, consistant à former une couche de stabilisation, entre la couche de photopolymère et la couche compressible, cette couche se présentant sous la forme d'une couche d'élastomère renforcée par un renfort fibreux, cet élastomère étant compatible chimiquement avec les polymères de la couche de photopolymère et de la couche compressible.

## Patentansprüche

1. Komprimierbare Flexodruckplatte, die dazu bestimmt ist, auf einer Stützwalze einer Druckmaschine angeordnet zu werden, wobei diese Platte (1, 2, 3, 4) eine Photopolymerschicht (10, 20, 30, 40) und eine komprimierbare Schicht (11, 21, 31, 41) aus einem Material umfasst, das Hohlräume aufweist, die zwischen 10 und 60 Vol.% dieser komprimierbaren Schicht bilden, wobei das Material mindestens 70 Gew.% eines Polymers oder einer Polymermischung einschließt, das chemisch mit dem Photopolymer vereinbar ist.

2. Druckplatte nach Anspruch 1, bei der die in der komprimierbaren Schicht vorhandenen Hohlräume von expandierten Mikrosphären gebildet sind.

3. Druckplatte nach Anspruch 2, bei der die Mikrosphären zwischen 1 und 10 Gew.% des die komprimierbare Schicht bildenden Materials darstellen.

4. Druckplatte nach einem der Ansprüche 1 bis 3, bei der die komprimierbare Schicht zwischen 0 und 3 Gew.% Schutzmittel umfasst, die insbesondere unter den Antioxidantien, den ozonhemmenden nicht fleckenden Mitteln des Phenoltyps oder den Wachsmitteln isoliert oder in Mischung ausgewählt werden.

5. Druckplatte nach einem der Ansprüche 1 bis 4, bei der die komprimierbare Schicht ein Basispolymer umfasst, das in einer der folgenden Gruppen ausgewählt wird:
- Elastomere des Typs Styrolcopolymere, beispielsweise SIS, SBS, SDS, (S-B)x, SEBS, SEPS einfach oder modifiziert; wobei diese Elastomere eventuell mit Biblock-Copolymeren gemischt sind, die beispielsweise Vinylgruppen, mit Isopren aufgepfropfte Ketten, Silane oder Anhydride umfassen.
- Thermoplastische Elastomere, die durch dynamische Vulkanisierung gewonnen werden, wie beispielsweise die Mischungen des Typs PP/EPDM oder PP/NBR;
- Thermoplastische Polyurethane, die rein oder modifiziert oder auch mit den Isocyanaten, beispielsweise TPU oder TPU, modifiziert mit Silanfunktionalitäten, vernetzt sind;
- Elastomere des Typs Acrylnitril, beispielsweise NBR, XNBR, HNBR und funktionalisierte NBR-Elastomere.

6. Druckplatte nach Anspruch 5, bei der die komprimierbare Schicht auch außer dem Basispolymer ein weiteres Polymer oder Polymer- oder Elastomerzusätze umfasst, die in einer oder mehrerer der folgenden Gruppen ausgewählt werden:
- Funktionalisierte Polyolefine, beispielsweise Ethylen-Copolymere mit Vinylacetat (EVA), mit Vinylalkohol (EVOH) oder Acrylester (EBA, EMA);
- Ethylen-, Vinylacetat- oder Acrylester-Terpolymere mit Maleinanhydrid oder Glycidilmethacrylat;
- Ethylen- und Octen-, Propylen- und Hexen- oder Decen-Copolymere;
- Polyester- oder Polyetheramide;
- Elastomere des Typs EPDM, NBR oder HNBR.

7. Druckplatte nach Anspruch 5 oder 6, bei der die komprimierbare Schicht Hilfsmittel umfasst, die insbesondere unter den mono- und multifunktionellen Acrylaten und Methacrylaten ausgewählt werden, beispielsweise HPMA, TMPTA, TMPTMA, HDDA oder GDMA alleine oder in Kombination.

8. Druckplatte nach den Ansprüchen 5 bis 7, bei der die komprimierbare Schicht funktionelle Polymere umfasst, die insbesondere unter den flüssigen Polymeren ausgewählt werden, beispielsweise EPDM 1,2 PB, Hydroxy- oder Epoxypoly- (Ethylen/Butylen) oder funktionalisiertes NBR.

9. Druckplatte nach einem der Ansprüche 5 bis 8, bei der die komprimierbare Schicht mineralische Füllstoffe umfasst, insbesondere Siliciumoxid, Silicate, Carbonate, reine oder an der Oberfläche modifizierte Stearate.

10. Druckplatte nach einem der Ansprüche 5 bis 9, bei der die komprimierbare Schicht Farbstoffe umfasst, insbesondere Pigmente und organische Farbstoffe in reiner oder gemischter Form.

11. Druckplatte nach einem der Ansprüche 5 bis 10, bei der die Bestandteile der komprimierbaren Schicht in folgenden Gewichtsverhältnissen vorhanden sind:
- Basispolymer ou élastomériques : de 0 à 60 % 35 bis 90 %
- andere Polymere oder Polymer- oder Elastomerzusätze ou élastomériques : de 0 à 60 % 0 bis 60 %
- Hilfsmittel und funktionelle Polymere ou élastomériques : de 0 à 60 % 0 bis 20 %
- Füllstoffe ou élastomériques : de 0 à 60 % 0 bis 10 %
- Farbstoffe ou élastomériques : de 0 à 60 % 0 bis 1 %
- Mikrosphären ou élastomériques : de 0 à 60 % 1 bis 10 %
- Schutzmittel ou élastomériques : de 0 à 60 % 0,1 bis 3 %

12. Druckplatte nach einem der Ansprüche 1 bis 11, bei der die komprimierbare Schicht mindestens ein funktionelles Monomer umfasst, das noch nicht mit den anderen Bestandteilen des Typs Polymer der komprimierbaren Schicht bei der Herstellung der Platte reagiert hat und das später unter der Wirkung einer bestimmten Spannung aktiviert werden kann, um weitere Bindungen zwischen den Polymerketten zu erzeugen oder welche zu unterdrücken.

13. Druckplatte nach Anspruch 12, bei der das oder die funktionellen Monomere unter den mono- und multifunktionellen Acrylaten und Methacrylaten des Typs HPMA, TMPTMA, HDDA, GDMA alleine oder in Kombination ausgewählt werden.

14. Druckplatte nach Anspruch 12 oder 13, bei der in der komprimierbaren Schicht zu diesem oder diesen funktionellen Monomeren mindestens ein Photoerreger oder ein Photoinitiator gemischt wird, der insbesondere zur Entwicklung einer photosensiblen Schicht verwendet wird.

15. Druckplatte nach einem der Ansprüche 12 bis 14, bei der dieses oder diese funktionellen Monomere zwischen 2 und 10 Gew.% der komprimierbaren Schicht darstellen, während dieser oder diese Photoerreger oder Photoinitiatoren zwischen 0 und 5 Gew.% der komprimierbaren Schicht vorhanden sind.

16. Druckplatte nach einem der Ansprüche 1 bis 15, umfassend eine Sohle zwischen der Photopolymerschicht und der komprimierbaren Schicht, die aus einem chemisch mit den Polymeren der Photopolymerschicht und der komprimierbaren Schicht vereinbaren Material hergestellt ist.

17. Druckplatte nach einem der Ansprüche 1 bis 16, umfassend eine Stabilisierungsschicht zwischen der Photopolymerschicht und der komprimierbaren Schicht.

18. Druckplatte nach Anspruch 17, bei der die Stabilisierungsschicht in Form einer Elastomerschicht, die chemisch mit dem Photopolymer und mit dem oder den Polymeren der komprimierbaren Schicht vereinbar ist, mit einer Fasergewebe- oder Faservliesverstärkung vorhanden ist.

19. Druckplatte nach einem der Ansprüche 1 bis 18, die an der Oberfläche der Photopolymerschicht auch eine Kontrastschicht umfasst.

20. Flexodruckplatte nach einem der Ansprüche 1 bis 19, die an der Oberfläche der Photopolymerschicht auch eine Schicht umfasst, die die Herstellung eines Bildes auf der Photopolymerschicht durch digitale Mittel ermöglicht.

21. Druckplatte nach einem der Ansprüche 1 bis 20, die in Form einer Folie vorhanden ist und auf ihrer Innenseite ein Kunststoff- oder Metallhäutchen umfasst.

22. Druckplatte nach einem der Ansprüche 1 bis 21, die auf ihrer Innenseite eine selbsthaftende Schicht umfasst.

23. Flexodruckplatte nach einem der Ansprüche 1 bis 22, deren Photopolymerschicht entwickelt ist.

24. Verfahren zur Herstellung einer Flexodruckplatte, die eine Photopolymerschicht umfasst, wobei dieses Verfahren die folgenden Schritte umfasst:
- Herstellung einer Mischung, die mindestens 70 Gew.% eines oder mehrerer Polymere, die chemisch mit dem Photopolymer vereinbar sind, 1 bis 10 Gew.% Mikrosphären im expandierten oder nicht expandierten Zustand oder Mischungen beider Typen von Mikrosphären oder Quellmittel umfasst;
- Extrusion dieser Mischung, während der die Mischung expandiert, um eine komprimierbare Schicht zu bilden, die eine Vielzahl von Hohlräumen aufweist;
- Extrusion des Photopolymers, um die Photopolymerschicht zu bilden;
- Walzen der Photopolymerschicht gegen die vorher gebildete komprimierbare Schicht, wobei der Druck einer Schicht gegen die andere zu einer Haftung zwischen ihnen führt, und
- Aktivierung eines Systems, um in der komprimierbaren Schicht lange Polymerketten zu erzeugen, die miteinander verknüpft sind, wobei dieser Aktivierungsschritt vor oder nach dem Walzen der Photopolymerschicht gegen die komprimierbare Schicht erfolgen kann.

25. Verfahren nach Anspruch 24, bei dem das System zur Erzeugung von langen, miteinander verknüpften Polymerketten ein Vernetzungssystem ist, das beispielsweise durch die Wärme, durch Isocyanate, Elektronenbeschuss oder auch Röntgenstrahlen aktiviert wird.

26. Verfahren nach Anspruch 24, bei dem das System zur Erzeugung der miteinander verknüpften Polymerketten in einer Befestigung der Polymerketten mittels einer kristallinen Phase bei Betriebstemperatur oder bei Raumtemperatur besteht.

27. Verfahren nach einem der Ansprüche 24 bis 26, umfassend einen zusätzlichen Schritt der Kalibrierung oder des Schleifens der komprimierbaren Schicht nach ihrer Extrusion.

28. Verfahren nach einem der Ansprüche 24 bis 27, bei dem die Mischung zwischen 0,1 und 3 Gew.% Schutzmittel umfasst, die insbesondere unter den Antioxidantien, den nicht fleckenden ozonhemmenden Mitteln des Phenoltyps oder den Wachsmitteln isoliert oder in Mischung ausgewählt werden.

29. Verfahren nach einem der Ansprüche 24 bis 27, bei dem die Mischung ein Basispolymer umfasst, das in einer der folgenden Gruppen ausgewählt wird:
- Elastomere des Typs Styrolcopolymere, beispielsweise SIS, SBS, SDS, (S-B)x, SEBS, SEPS einfach oder modifiziert, sowie die Mischung dieser Elastomere mit Biblock-Copolymeren, die beispielsweise Vinylgruppen, mit Isopren aufgepfropfte Ketten, Silane oder Anhydride umfassen.
- Thermoplastische Elastomere, die durch dynamische Vulkanisierung gewonnen werden, wie beispielsweise die Mischungen des Typs PP/EPDM oder PP/NBR;
- Thermoplastische Polyurethane, die rein oder modifiziert oder auch mit den Isocyanaten, beispielsweise TPU oder TPU, modifiziert mit Silanfunktionalitäten, vernetzt sind;
- Elastomere des Typs Acrylnitril, beispielsweise NBR, XNBR, HNBR und funktionalisierte NBR-Elastomere.

30. Verfahren nach Anspruch 29, bei dem die Mischung auch außer dem Basispolymer ein weiteres Polymer oder Polymer- oder Elastomerzusätze umfassen kann, die in einer oder mehreren der folgenden Gruppen ausgewählt werden:
- Funktionalisierte Polyolefine, beispielsweise Ethylen-Copolymere mit Vinylacetat (EVA), mit Vinylalkohol (EVOH) oder Acrylester (EBA, EMA);
- Ethylen-, Vinylacetat- oder Acrylester-Terpolymere mit Maleinanhydrid oder Glycidilmethacrylat;
- Ethylen- und Octen-, Propylen- und Hexen- oder Decen-Copolymere;
- Polyester- oder Polyetheramide;
- Elastomere des Typs EPDM, NBR oder HNBR.

31. Verfahren nach Anspruch 29 oder 30, bei dem die Mischung, die die komprimierbare Schicht bildet, Hilfsmittel umfasst, die insbesondere unter den mono- und multifunktionellen Acrylaten und Methacrylaten ausgewählt werden, beispielsweise HPMA, TMPTA, TMPTMA, HDDA oder GDMA alleine oder in Kombination.

32. Verfahren nach einem der Ansprüche 29 bis 31, bei dem die Mischung, die die komprimierbare Schicht bildet, funktionelle Polymere umfasst, die insbesondere unter den flüssigen Polymeren ausgewählt werden, beispielsweise EPDM 1,2 PB, Hydroxy- oder Epoxypoly- (Ethylen/Butylen) oder funktionalisiertes NBR.

33. Verfahren nach einem der Ansprüche 29 bis 32, bei dem die Mischung auch mineralische Füllstoffe umfasst, insbesondere Siliciumoxid, Silicate, Carbonate, reine oder an der Oberfläche modifizierte Stearate.

34. Verfahren nach einem der Ansprüche 29 bis 33, bei dem die Mischung auch Farbstoffe umfasst, insbesondere Pigmente und organische Farbstoffe in reiner oder gemischter Form.

35. Verfahren nach einem der Ansprüche 29 bis 34, bei dem die verschiedenen Bestandteile der Mischung, die die Bildung der komprimierbaren Schicht ermöglichen, in folgenden Gewichtsverhältnissen vorhanden sind:
- Basispolymer ou élastomériques : de 0 à 60 % 35 bis 90 %
- andere Polymere oder Polymer- oder Elastomerzusätze ou élastomériques : de 0 à 60 % 0 bis 60 %
- Hilfsmittel und funktionelle Polymere 0 bis 20 %
- Füllstoffe 0 bis 10 %
- Farbstoffe 0 bis 1 %
- Mikrosphären 1 bis 10 %
- Schutzmittel 0,1 bis 3 %

36. Verfahren nach einem der Ansprüche 29 bis 35, bei dem die Mischung, die die Bildung der komprimierbaren Schicht ermöglicht, mindestens ein funktionelles Monomer umfasst, das nicht mit den anderen Beständteilen des Typs Polymer der komprimierbaren Schicht reagiert und das später unter der Wirkung einer bestimmten Spannung aktiviert werden kann.

37. Verfahren nach Anspruch 36, bei dem das oder die funktionellen Monomere unter den mono- und multifunktionellen Acrylaten und Methacrylaten des Typs HPMA, TMPTMA, HDDA, GDMA alleine oder in Kombination ausgewählt werden.

38. Verfahren nach Anspruch 36 oder 37, bei dem dieses oder diese funktionellen Monomere vorzugsweise mit mindestens einem Photoerreger oder einem Photoinitiator gemischt werden.

39. Verfahren nach einem der Ansprüche 36 bis 38, umfassend einen zusätzlichen Schritt, der darin besteht, dieses oder diese funktionellen Monomere zu aktivieren, um selektiv die Komprimierbarkeit der Druckplatte zu modifizieren.

40. Verfahren nach einem der Ansprüche 24 bis 39, umfassend einen zusätzlichen Schritt der Herstellung einer Sohle zwischen der Photopolymerschicht und der komprimierbaren Schicht.

41. Verfahren nach einem der Ansprüche 29 bis 40, umfassend einen zusätzlichen Schritt der Herstellung einer Stabilisierungsschicht zwischen der Photopolymerschicht und der komprimierbaren Schicht, wobei diese Schicht in Form einer Elastomerschicht, die mit einer Faserverstärkung verstärkt ist, vorhanden ist, wobei dieses Elastomer chemisch mit den Polymeren der Photopolymerschicht und der komprimierbaren Schicht vereinbar ist.

## Claims

1. Compressible flexographic printing plate, intended to be positioned on a supporting cylinder of a printing machine, this plate (1, 2, 3, 4) including a photopolymer layer (10, 20, 30, 40) and a compressible layer (11, 21, 31, 41) of a material having empty spaces which form between 10 and 60% by volume of this compressible layer, the material including at least 70% by weight of a polymer or a mixture of polymers which is chemically compatible with the photopolymer.

2. Printing plate according to claim 1, in which the empty spaces present in the compressible layer are formed by expanded microspheres.

3. Printing plate according to claim 2, in which the microspheres represent between 1 and 10% by weight of the material forming the compressible layer.

4. Printing plate according to any one of claims 1 to 3, in which the compressible layer includes between 0 and 3% by weight of protective agents, chosen in particular from antioxidants, non-staining phenolic antiozonants or waxes, taken in isolation or in a mixture.

5. Compressible plate according to any one of claims 1 to 4, in which the compressible layer includes a base polymer which is chosen from one of the following groups
- Styrene copolymer type elastomers, for example SIS, SBS, SDS, (S-B)x, SEBS, SEPS simple and modified; these elastomers possibly being mixed with diblock copolymers, including for example vinylic groups, grafted chains of isoprene, silanes, or anhydrides.
- Thermoplastic elastomers obtained by dynamic vulcanisation, such as, for example, PP/EPDM or PP/NBR type mixtures.
- Thermoplastic polyurethanes, pure or modified, or cross-linked with isocyanates, for example TPU or TPU modified with silane functions.
- Acrylonitrile type elastomers, for example NBR, XNBR, HNBR and functionalised NBR elastomers.

6. Printing plate according to claim 5, in which the compressible layer also includes, besides the base polymer, another polymer or polymeric or elastomeric additives chosen from one or more than one of the following groups:
- Functionalised polyolefins, for example ethylene copolymers with vinyl acetate (EVA), with vinylic alcohol (EVOH) or acrylic ester (EBA, EMA).
- Terpolymers of ethylene, vinyl acetate or acrylic ester with maleic anhydride or glycidyl methacrylate.
- Copolymers of ethylene and octene, of propylene and hexene or decene.
- Polyester or polyether amides.
- Elastomers of the type EPDM, NBR, HNBR.

7. Printing plate according to claim 5 or 6, in which the compressible layer includes coagents chosen in particular from mono- and multi-functional acrylates and methacrylates, for example HPMA, TMPTA, TMPTMA, HDDA or GDMA, alone or in combination.

8. Printing plate according to claims 5 to 7, in which the compressible layer includes functional polymers chosen in particular from liquid polymers and for example EPDM 1.2 PB, hydroxy or epoxy poly (ethylene/butylene), or functionalised NBR.

9. Printing plate according to any one of claims 5 to 8, in which the compressible layer includes mineral fillers, in particular silica, silicates, carbonates, stearates, pure or surface modified.

10. Printing plate according to any one of claims 5 to 9, in which the compressible layer includes colorants, in particular organic pigments and colorants, pure or in mixed form.

11. Printing plate according to any one of claims 5 to 10, in which the constituents of the compressible layer are present in the following proportions by weight:
- Base polymers: from 35 to 90%
- Other polymers or polymeric or elastomeric additives from 0 to 60%
- Coagents and functional polymers from 0 to 20%
- Fillers: from 0 to 10%
- Colorants: from 0 to 1%
- Microspheres: from 1 to 10%
- Protective agents: from 0.1 to 3%

12. Printing plate according to any one of claims 1 to 11, in which the compressible layer includes at least one functional monomer which has not yet reacted with the other polymeric constituents of the compressible layer during manufacture of the plate and which is capable of being activated subsequently under the effect of a predetermined stress, in order to create other links between the polymer chains or to suppress links.

13. Printing plate according to claim 12, in which the one or more than one functional monomer is chosen from mono-and multi-functional acrylates and methacrylates of the type HPMA, TMPTA, TMPTMA, HDDA, GDMA, alone or in combination.

14. Printing plate according to claim 12 or 13, in which at least one photocatalyst or photoinitiator, in particular one which can be used to develop a photosensitive layer, is mixed in the compressible layer with this or these functional monomers.

15. Printing plate according to any one of claims 12 to 14, in which this or these functional monomers represent between 2 and 10% by weight of the compressible layer, while this or these photocatalysts or photoinitiators form between 0 and 5% by weight of the compressible layer.

16. Printing plate according to any one of claims 1 to 15, including a floor, between the photopolymer layer and the compressible layer, made of a material chemically compatible with the polymers in the photopolymer layer and the compressible layer.

17. Printing plate according to any one of claims 1 to 16, including a stabilising layer, between the photopolymer layer and the compressible layer.

18. Printing plate according to claim 17, in which the stabilising layer is present in the form of a layer of elastomer, chemically compatible with the photopolymer and with the one or more than one polymer in the compressible layer, with a fibrous woven or non-woven reinforcement.

19. Printing plate according to any one of claims 1 to 18, also including, on the surface of the photopolymer layer, a contrast layer.

20. Flexographic printing plate according to any one of claims 1 to 19, also including, on the surface of the photopolymer layer, a layer allowing an image to be produced on the photopolymer layer, by digital means.

21. Printing plate according to any one of claims 1 to 20, produced in the form of a sheet and including on its internal face a film of a plastic material or of metal.

22. Printing plate according to any one of claims 1 to 21, including on its internal face a self-adhesive.

23. Flexographic printing plate according to any one of claims 1 to 22, whose photopolymer layer is developed.

24. Process for production of a flexographic printing plate including a photopolymer layer, this process including the following stages:
- Preparation of a mixture including at least 70% by weight of one or more than one polymer chemically compatible with the photopolymer, 1 to 10% by weight of microspheres in an expanded or non-expanded state or mixtures of the two types of microspheres, or of swelling agents;
- Extrusion of this mixture, during which the mixture expands, to form a compressible layer having a multiplicity of empty spaces;
- Extrusion of the photopolymer to form the photopolymer layer;
- Calendering of the layer of photopolymer against the previously formed compressible layer, the pressure of one layer against the other causing them to adhere to one another and
- Activation of a system for the creation, within the compressible layer, of long chains of polymers linked to one another, this activation stage being capable of being effected before or after the calendering of the layer of photopolymer against the compressible layer.

25. Process according to claim 24, in which the system for the creation of long chains of polymers linked to one another is a system of crosslinking, activated for example by heat, by isocyanates, by electron bombardment or by X rays.

26. Process according to claim 24, in which the system for the creation of long chains of polymers linked to one another consists of setting chains of polymers by means of a crystalline phase, at the operating temperature or at the ambient temperature.

27. Process according to any one of claims 24 to 26, including an additional stage of calibration or rectification of the compressible layer, after it has been extruded.

28. Process according to any one of claims 24 to 27, in which the mixture includes between 0.1 and 3% by weight of protective agents, chosen in particular from antioxidants, non-staining phenolic antiozonants or waxes, taken in isolation or in a mixture.

29. Process according to any one of claims 24 to 27, in which the mixture includes a base polymer which is chosen from one of the following groups:
- Styrene copolymer type elastomers, for example SIS, SBS, SDS, (S-B)x, SEBS, SEPS simple and modified, and mixtures of such elastomers with diblock copolymers, including for instance vinylic groups, grafted chains of isoprene, silanes, or anhydrides.
- Thermoplastic elastomers obtained by dynamic vulcanisation, such as, for example, mixtures of a PP/EPDM or PP/NBR type.
- Thermoplastic polyurethanes, pure or modified, or cross-linked with isocyanates, for example TPU and TPU modified with silane functions.
- Acrylonitrile type elastomers, for example NBR, XNBR, HNBR and functionalised NBR elastomers.

30. Process according to claim 29, in which the mixture may also include, besides the base polymer, another polymer or polymeric or elastomeric additives chosen from one or more than one of the following groups:
- Functionalised polyolefins, for example ethylene copolymers with vinyl acetate (EVA), with vinylic alcohol (EVOH) or acrylic ester (EBA, EMA).
- Terpolymers of ethylene, vinyl acetate or acrylic ester with maleic anhydride or glycidyl methacrylate.
- Copolymers of ethylene and octene, of propylene and hexene or decene.
- Polyester or polyether amides.
- Elastomers of an EPDM, NBR or HNBR type.

31. Process according to claim 29 or 30, in which the mixture forming the compressible layer also includes coagents chosen in particular from mono-and multi-functional acrylates and methacrylates, for example HPMA, TMPTA, TMPTMA, HDDA or GDMA, alone or in combination.

32. Process according to any one of claims 29 to 31, in which the mixture forming the layer also includes functional polymers chosen in particular from liquid polymers, for example EPDM, 1.2 PB, hydroxy or epoxy (ethylene/butylene) or functionalised NBR

33. Process according to any one of claims 29 to 32, in which the mixture also includes mineral fillers, particularly of the types silica, silicates, carbonates, stearates, pure or surface modified.

34. Process according to any one of claims 29 to 33, in which the mixture also includes colorants, in particular organic pigments and colorants, pure or in mixed form.

35. Process according to any one of claims 29 to 34, in which the different constituents of the mixture enabling the compressible layer to be formed are present in the mixture in the following proportions by weight:
- Base polymers: 35 to 90%
- Other elastomer or polymeric or elastomeric additives 0 to 60%
- Coagents and functional polymers 0 to 20%
- Fillers: 0 to 10%
- Microspheres or swelling agents: 1 to 10%
- Colorants: 0 to 1%
- Protective agents: 0.1 to 3%

36. Process according to any one of claims 29 to 35, in which the mixture enabling the compressible layer to be formed includes at least one functional monomer which does not react with the other polymeric constituents of the compressible layer and which is capable of being activated subsequently under the effect of a predetermined stress.

37. Process according to claim 36, in which the one or more than one functional monomer is chosen from mono- and multi-functional acrylates and methacrylates, particularly of the types HPMA, TMPTA, TMPTMA, HDDA, GDMA, alone or in combination.

38. Process according to claim 36 or 37, in which the one or more than one functional monomer is advantageously mixed with at least one photocatalyst or photoinitiator.

39. Process according to any one of claims 36 to 38, including an additional stage consisting of the activation of this one or more than one functional monomer in order to selectively modify the compressibility of the printing plate.

40. Process according to any one of claims 24 to 39, including an additional stage consisting of the production of a floor between the photopolymer layer and the compressible layer.

41. Process according to any one of claims 29 to 40, including an additional stage consisting of the formation of a stabilising layer, between the photopolymer layer and the compressible layer, this layer being in the form of a layer of elastomer reinforced by a fibrous reinforcement, this elastomer being chemically compatible with the polymers in the photopolymer layer and the compressible layer.
